# EUROPÄISCHE PATENTSCHRIFT

(11) **EP 0 776 153 B1**
(45) Veröffentlichungstag und Bekanntmachung des Hinweises auf die Patenterteilung: **26.08.1998**
(21) Anmeldenummer: 96117581.7
(22) Anmeldetag: 02.11.1996
(51) Int. Cl.: H05K 9/00, C04B 28/14

(54) **Verfahren zur Abschirmung von Räumen gegen elektromagnetische Strahlung**
Method for electromagnetic shielding of enclosures
Méthode pour le blindage électromagnétique de locaux

(30) Priorität: 24.11.1995 DE 19543877
(43) Veröffentlichungstag der Anmeldung: 28.05.1997
(73) Patentinhaber: Gebr. Knauf Westdeutsche Gipswerke KG, D-97343 Iphofen (DE)
(72) Erfinder: Berneth, Claus-Peter, Dr., 97340 Marktbreit (DE); Hummel, Hans-Ulrich, Prof. Dr., 97348 Markt Einersheim (DE)
(74) Vertreter: Werner, Hans-Karsten, Dr.Dipl.-Chem.

(56) Entgegenhaltungen:
- EP-A- 0 585 184
- WO-A-90/14321
- DE-A- 3 131 137
- DE-A- 4 209 730
- US-A- 4 540 624
- PATENT ABSTRACTS OF JAPAN vol. 16, no. 283 (C-955), 24.Juni 1992 & JP 04 074747 A (DENKI KAGAKU KOGYO KK), 10.März 1992,
- CHEMICAL ABSTRACTS, vol. 116, no. 4, 27.Januar 1992 Columbus, Ohio, US; abstract no. 26811d, "Manufacture of carbon fiber-reinforced dry mortar and paint thereof" XP000285335 & JP 03 197 344 A (SHOWA SHELL SEKIYU K.K,.)
- CHEMICAL ABSTRACTS, vol. 105, no. 10, 8.September 1986 Columbus, Ohio, US; abstract no. 84281q, "Fiber-reinforced building materials" XP000061424 & JP 06 149 803 A (MITSUI CONSTRUCTION CO. LTD)

## Beschreibung

Gegenstand der vorliegenden Erfindung ist ein Verfahren zur Abschirmung von Räumen gegen elektromagnetische Strahlung durch elektrisch leitende Schichten.

Elektromagnetische Felder zählen inzwischen zu den Umweltfaktoren des Menschen. Weiterhin ist es in zunehmendem Maße nötig, technisch genutzte Räume mit empfindlichen Meß- und Steuerungsgeräten sowie Computer vor unerwünschten elektromagnetischen Wellen abzuschirmen.

Bisher erfolgt diese Abschirmung dadurch, daß die Räume mit elektrisch leitenden Schichten ausgekleidet werden. Die bisher am häufigsten zur Anwendung kommende Methode ist die Anbringung eines leitfähigen Metallnetzes, wobei dieses vorzugsweise mit einem flexiblen Träger aus Papier, Gewebe, Kunststoffasern und/oder Naturfasern ummantelt wird; vgl. DE-A-42,09,730.

Aus der DE-C-31 31 137 ist eine Vorrichtung zur Abschirmung und Absorption von elektromagnetischen Feldern bekannt, bestehend aus Metallfaserbeton, dessen elektrisch leitende Fasern bezüglich ihrer Länge in Abhängigkeit von der Frequenz und bezüglich ihrer Orientierung in Abhängigkeit von der Polarisationsrichtung der abzuschirmenden bzw. zu absorbierenden elektromagnetischen Wellen im Beton angeordnet sind. Diese Vorrichtung soll besser ein als solche, die ferritoder kohlenstoffhaltige Materialien wie Graphit enthalten, oder gar eine Metallfolie. Die neue Vorrichtung soll witterungsunempfindlich sein und keine zusätzliche Stützkonstruktion benötigen. Es wird zwar erwähnt, daß das Bindemittel sowohl hydraulisch abbindend sein kann, wie Zement, Kalk, Gips, als auch aus Kunststoff oder ähnlichen Materialien bestehen kann. Für den dort beschriebenen Zweck kommen aber nur witterungsunempfindliche Materialien in Frage.

Aus der EP-A-0,585,184 ist ein Baumaterial bekannt, welches gegen elektromagnetische Strahlen abschirmt. Es besteht aus einem hydraulisch abbindenden anorganischen Material und 0,6 bis 3 Gew.-% Carbonfasern. Unter anderem soll auch Gips als Bindemittel zum Einsatz kommen. Vorzugsweise besteht aber dieses Material aus vorgefertigten Betonteilen, die mit einer leitfähigen Schicht überzogen werden. Dabei sind Schichtdicken der Mörtelschicht zwischen 5 und 10 mm notwendig, um die gewünschte Leitfähigkeit und damit Abschirmwirkung zu erreichen. Die Länge der Carbonfasern beträgt durchschnittlich 4 bis 30 mm. Als Trägermaterial wird weiterhin auch die Gipskartonplatte genannt, die mit dem hydraulisch abbindenden Material und den Carbonfasern beschichtet werden soll.

Ein Nachteil dieser vorgefertigen Baumaterialien ist die relative Empfindlichkeit gegen mechanische Zerstörungen während des Transports und der Montage. Außerdem ist es notwendig, die einzelnen Bauelemente nach dem Einbau elektrisch leitend miteinander zu verbinden, um sie anschließend insgesamt leitend mit der Erde verbinden zu können.

Besonders nachteilhaft wirken sich die Schichtdicken des leitfähigen Materials von 5 bis 10 mm aus. Dies ist besonders aus wirtschaftlichen Überlegungen nachteilhaft, da die benötigten Carbonfasern im Gegensatz zum eigentlichen Bindemittel extrem hochpreisig sind.

Die Erfindung hat sich die Aufgabe gestellt, die Abschirmung von Räumen gegen elektromagnetische Strahlung durch elektrisch leitende Schichten zu vereinfachen und preiswerter durchführen zu können, wobei auch möglichst wenige zusätzliche Montageschritte nötig sind und dennoch eine zuverlässige Abschirmung gewährleistet wird, vor allem mit einer möglichst geringen Schichtdicke des leitfähigen Materials.

Diese Aufgabe kann überraschend einfach gelöst werden dadurch, daß die abzuschirmenden Räume verputzt werden mit einer höchstens 2 mm starken, gipsgebundenen Dünnputzschicht, welche mindestens 0,8 Gew.-% Carbonfasern enthält, wobei die Länge der Carbonfasern höchstens 3 mm beträgt, und wobei die abgebundene Dünnputzschicht leitend mit der Erde verbunden wird.

Eine ausreichende Tiefenleitfähigkeit wird insbesondere dadurch erreicht, indem als Ausgangsmaterial Calciumsulfat-Halbhydrat der α- und/oder β-Modifikation verwendet wird mit einer Korngröße < 200 µm, vorzugsweise < 150 µm. Außerdem kann ein feines Kalksteinmehl der Körnung < 150 µm als inertes Füllmaterial im Konzentrationsbereich < 30 Gew.-% eingesetzt werden.

Vorzugsweise werden Carbonfasern in Form von geschnittenen, geschlichteten Carbonfasern eingesetzt, die mit wasserlöslichen Klebern verklebt sind. Derartige Carbonfasern lassen sich leicht und zuverlässig mit dem Gips für die Dünnputzschicht vermischen, so daß eine homogene und zuverlässig leitende Dünnputzschicht entsteht. Die Länge der Carbonfasern sollte höchstens 3 mm betragen und damit nicht merklich länger sein als die Dicke der Dünnputzschicht, da dies dazu führt, daß die fertige Dünnputzschicht zuverlässig und gleichmäßig verteilte Carbonfasern enthält, die es gestatten, die Schicht leitend mit der Erde zu verbinden und damit auch die gewünschte Abschirmung zu gewährleisten.

Die Dicke der Carbonfasern beträgt im allgemeinen 1 bis 20 µm. Besonders bewährt haben sich Faserdurchmesser zwischen 5 und 10 µm. Bei Verwendung des oben genannten Calciumsulfat-Halbhydrats entstehen durch Pseudomorphose und Epitaxie, d.h. gerichtetes Aufwaschen von Gipskristallen auf die Faser, Porenräume in der Bindemittelschicht, die ein optimales Einbetten der Carbonfasern gestatten (REM-Aufnahmen 1 und 2). Dadurch wird selbst bei Schichtdicken von nur 2 mm eine optimale 3-d-Tiefenleitfähigkeit und Schirmdämpfung erreicht. Die Meßwerte können dem anliegenden Meßdiagramm entnommen werden.

Die Carbonfasern bewirken zudem eine, im Vergleich zu herkömmlichen Dünnputzen, erhöhte mechanische Stabilität. Dies ist auf den optimalen Verbund von Faser und Gipsmatrix zurückzuführen.

Die Menge an Carbonfasern beträgt mindestens 0,8 Gew.-% und wird vorzugsweise zwischen 1,5 und 3 Gew.-% gewählt, je nach Anforderung an die Abschirmung. Wesentlich höhere Mengen an Carbonfasern führen zu keiner wesentlichen Steigerung der Abschirmung, erhöhen aber die Kosten und verschlechtern gegebenenfalls sogar die mechanische Stabilität der Dünnputzschicht. Optimale Ergebnisse werden insbesondere beobachtet, wenn die Länge der Carbonfasern genau der Dicke der Dünnputzschicht entspricht. Bei wesentlich kürzeren Fasern besteht die Gefahr, daß die Schicht nicht durchgehend ausreichend leitfähgi ist. Bei wesentlich längeren Fasern besteht die Gefahr, daß eine gleichmäßige Verteilung innerhalb der Schicht erschwert ist und nicht nur die Leitfähigkeit gestört ist, sondern auch die Oberflächenstruktur der Dünnputzschicht leidet.

Für die Durchführung des erfindungsgemäßen Verfahrens haben sich besonders gut bewährt die Carbonfasern vom Typ GL, wie sie für wäßrige Klebstoffysteme, Vliese und Papiere sowie wäßrige Mischverfahren entwickelt worden sind. Diese Fasern werden von der Sigri Great Lakes Carbon GmbH in Meitingen/ Deutschland angeboten.

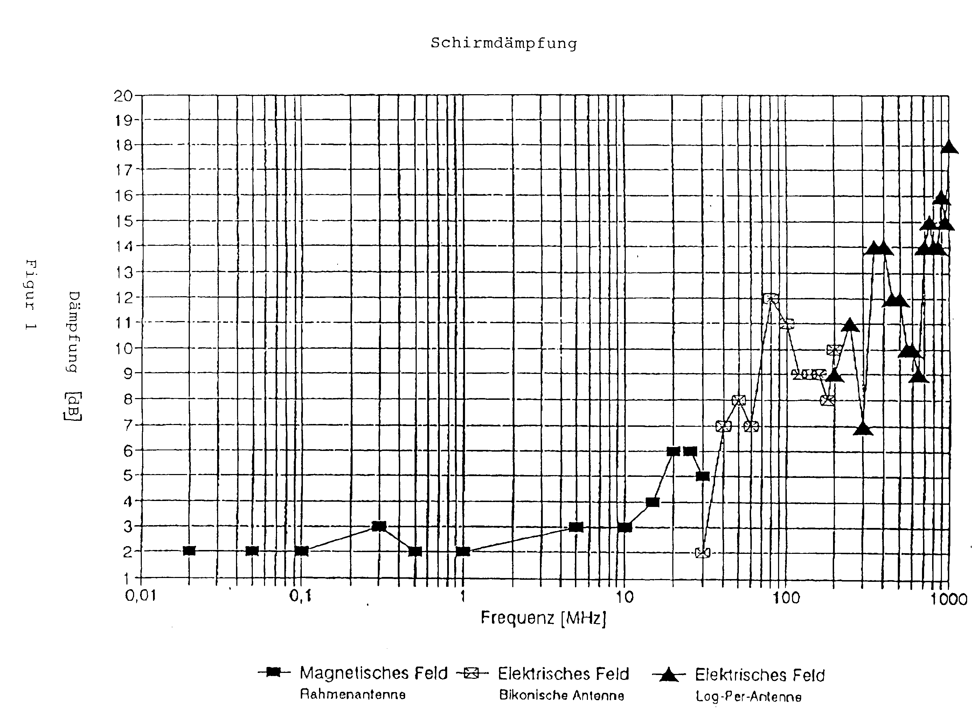

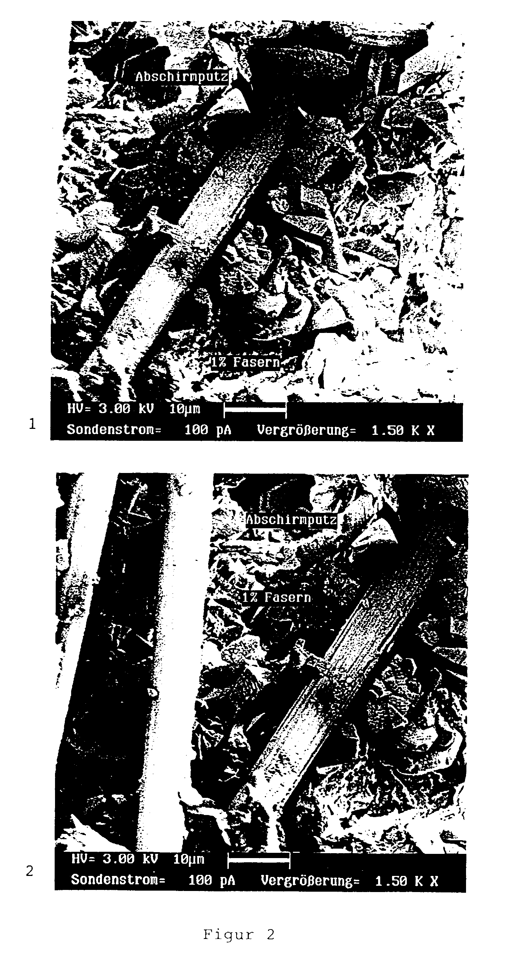

## Patentansprüche

1. Verfahren zur Abschirmung von Räumen gegen elektromagnetische Strahlung durch elektrisch leitende Schichten, dadurch gekennzeichnet, daß die Räume verputzt werden mit einer höchstens 2 mm starken Dünnputzschicht aus Gips, welche mindestens 0,8 Gew.-% Carbonfasern enthält, wobei die Länge der Carbonfasern höchstens 3 mm beträgt, und wobei die abgebundene Dünnputzschicht leitend mit der Erde verbunden wird.

2. Verfahren gemäß Anspruch 1, dadurch gekennzeichnet, daß die Carbonfasern in Form von geschnittenen, geschlichteten Carbonfasern eingebracht werden, die mit wasserlöslichen Klebern verklebt sind.

3. Verfahren gemäß Anspruch 1 oder 2, dadurch gekennzeichnet, daß das Bindemittel aus α- und/oder β-Halbhydrat der Körnung < 200 µm besteht.

4. Verfahren gemäß einem der Ansprüche 1 bis 3, dadurch gekennzeichnet, daß dem Bindemittel bis zu 30 Gew.-% Kalksteinmehl der Körnung < 150 µm zugesetzt wird.

## Claims

1. A method for screening rooms against electromagnetic radiation by electrically conducting layers, characterized in that said rooms are plastered with a thin plaster layer of gypsum having a thickness of at most 2 mm and containing at least 0.8% by weight of carbon fibers, the length of said carbon fibers being at most 3 mm, wherein the set thin plaster is conductively connected to the ground.

2. The method according to claim 1, characterized in that said carbon fibers are introduced in the form of cut and sized carbon fibers which are bonded together with watersoluble adhesives.

3. The method according to claim 1 or 2, characterized in that the binder consists of α- and/or β-semihydrate with a grain size of < 200 µm.

4. The method according to any of claims 1 to 3, characterized in that powdered limestone with a grain size of < 150 µm is added to the binder in a proportion of up to 30% by weight.

## Revendications

1. Procédé pour protéger des pièces contre un rayonnement électromagnétique par des couches électroconductrices, caractérisé en ce qu'on revêt les parois des pièces avec une couche mince d'enduit, d'une épaisseur maximale de 2 mm, formée de plâtre qui contient 0,8 % en poids de fibres de carbone, la longueur des fibres de carbone étant d'au plus 3 mm, et la couche mince d'enduit après la prise étant reliée à la terre de façon conductrice.

2. Procédé selon la revendication 1, caractérisé en ce qu'on introduit les fibres de carbone sous la forme de fibres de carbone coupées et encollées et qu'on les colle avec des colles solubles dans l'eau.

3. Procédé selon la revendication 1 ou 2, caractérisé en ce que le liant est formé de semi-hydrate a et/ou de semi-hydrate β ayant une dimension de grains < 200 µm.

4. Procédé selon l'une des revendications 1 à 3, caractérisé en ce qu'on ajoute jusqu'à 30 % en poids de poudre de pierre à chaux, ayant une dimension de grains < 150 µm, au liant.
